(19) Europäisches Patentamt / European Patent Office / Office européen des brevets

(11) **EP 4 345 823 A1**

(12) **EUROPEAN PATENT APPLICATION**

(43) Date of publication:
**03.04.2024 Bulletin 2024/14**

(21) Application number: **22214910.6**

(22) Date of filing: **20.12.2022**

(51) International Patent Classification (IPC):
**G11C 13/00** (2006.01)   **G11C 11/56** (2006.01)
**G11C 11/54** (2006.01)   **G06N 3/063** (2023.01)

(52) Cooperative Patent Classification (CPC):
**G11C 13/003; G06N 3/065; G11C 11/54;**
**G11C 11/5685; G11C 13/0026; G11C 13/0069;**
G11C 2013/0078; G11C 2213/75; G11C 2213/79;
G11C 2213/82

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **30.09.2022 EP 22199224**

(71) Applicants:
• **IHP GmbH - Innovations for High Performance**
**Microelectronics / Leibniz-Institut für**
**innovative Mikroelektronik**
**15236 Frankfurt (Oder) (DE)**
• **Brandenburgische Technische Universität**
**Cottbus-Senftenberg**
**03046 Cottbus (DE)**

(72) Inventors:
• **Uhlmann, Max**
**15236 Frankfurt (Oder) (DE)**
• **Kahmen, Gerhard**
**15236 Frankfurt (Oder) (DE)**
• **Ostrovskyy, Philip**
**15236 Frankfurt (Oder) (DE)**
• **Reichenbach, Marc**
**03046 Cottbus (DE)**
• **Fritscher, Markus**
**15236 Frankfurt (Oder) (DE)**

(74) Representative: **Eisenführ Speiser**
**Patentanwälte Rechtsanwälte PartGmbB**
**Stralauer Platz 34**
**10243 Berlin (DE)**

(54) **RESISTIVE MEMORY SUBCELL, RESISTIVE RANDOM ACCESS MEMORY FOR IN-MEMORY-COMPUTING AND IN-MEMORY-PROCESSOR**

(57)    A resistive random access memory (RRAM) subcell comprises a subcell circuit arrangement having an electrical series connection of interconnected or interconnectable memristors. Each of the memristors is electrically programmable to assume a selected one of a plurality of memristor states, each memristor state being associated with a respective memristor resistance value or memristor resistance-value range of the given memristor. The subcell circuit arrangement is electrically drivable to assume a selected one of a set of memory subcell states for storing information, the set of memory subcell states comprising those combinations of memristor states in the subcell circuit arrangement, which result from the electrical series connection of the memristors and have mutually distinguishable subcell resistance values or subcell resistance-value ranges. The electrical circuit arrangement of the RRAM subcell is operated using a single bitline.

Fig. 4

## Description

The invention relates to a resistive memory subcell for use in a resistive random access memory (RRAM), herein RRAM subcell, and to a RRAM memory based on the RRAM subcell.

Artificial neural networks are currently main tools to solve tasks such as image or audio recognition. Vector-matrix multiplication (VMM) is an arithmetic operation employed in these networks. An input vector of a layer of a neural network is multiplied by a matrix of weights.

In computer structures according to the von Neumann architecture, these operations have to be executed sequentially. This is often not energy-efficient nor fast enough for today's application requirements. Parallel in-memory computing (IMC) architectures are considered a better alternative in these aspects. These structures can be implemented in different ways.

One approach to emulating neural networks is an arrangement of memristors in a matrix, herein also referred to as Resistive Random Access Memory - RRAM.

Memristors, other than resistors, exhibit a dynamic relationship between current and voltage, including a memory of past voltages or currents. Memristors may be described in simplified terms as exhibiting a programmable ohmic resistance. In hardware representations of artificial neural networks, the programmability of the ohmic resistance can be used to store and apply a weight factor to an input of a programming cell representing an artificial neuron.

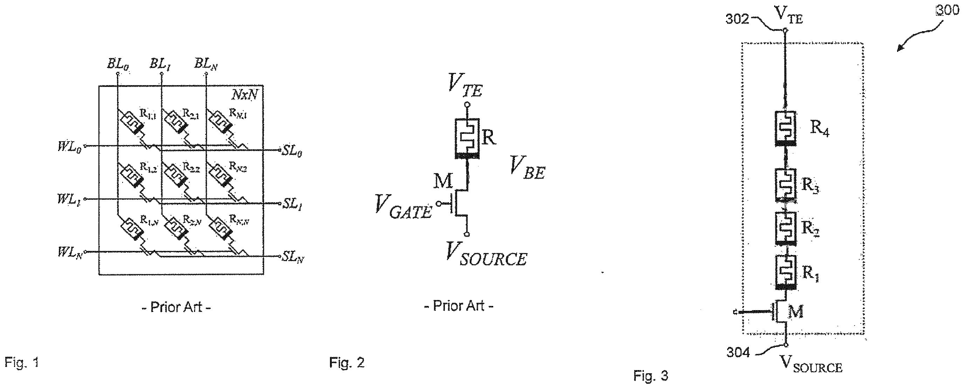

The following description refers to Figs. 1 and 2 in parallel. Fig. 1 illustrates a known structure of an NxN RRAM matrix for in-memory computing. Fig. 2 illustrates a memory cell forming an elementary building block of the RRAM matrix of Fig. 1 and a representation of a synaptic weight connection of an artificial neural network. Memristors in each matrix row, such as the memristors R1,1 to RN,1 in the first row, receive an input voltage vector ($BL_0$, BLi, ... $BL_N$) on their top electrode. On their bottom electrode, which may be considered an output side, the memristors are connected with a drain contact of a respective NMOS field effect transistor M. The memristor R is connected to the drain contact of the N-channel MOS FET M . This forms 1T1R cell. The source contacts of the NMOS transistors in a matrix row are connected to a source line SL0, SL1, ..., SLN commonly associated with the memristors of the given matrix row 0, 1, ...,N. The NMOS transistors of a given matrix row 0, 1, ..., N are commonly gated by a same wordline signal $WL_0$, $WL_1$, ..., or $WL_N$. The transistors thus serve as switches for activation or deactivation of the matrix row in a vector matrix multiplication operation.

The transistors M are also used to define a maximum current through the memristor during the setting of a state of the memristor. By this process, a given memristor can be programmed to exhibit one resistance value from a set of programmable resistance values. In RRAM cells, each bit value is associated to a respective range of resistance values There are gaps between the resistance value ranges in order to unambiguously determine a resistance range in a read operation even in the presence of noise.

The current component through each of the memristors of an activated matrix line is determined by the value of the input vector multiplied a reciprocal value of the programmed ohmic resistance (i.e., the conductance) of the memristor. In a vector-matrix multiplication operation, the matrix may represent weight factors. Thus, the programmed ohmic resistance values of the circuit arrangement of memristors of an activated matrix row determine a sum current flowing in the activated matrix source line, according to Ohm's and Kirchhoff's laws. For example, in the first matrix row, a sum current is provided at a source line $SL_0$ that has an amount corresponding to a weighted sum of the input vector $BL_0$, $BL_1$, ... $BL_N$. A corresponding operation is performed within the same clock cycle in every other activated matrix row . An output current vector SL will then be determined by measuring the current in each matrix row. The multiplication and addition operations of a vector-matrix multiplication are thus implemented by the circuit topology of the RRAM matrix.

The accuracy of the output provided by a neural network, for example in classification applications, depends on the resolution of the weights as given by the number of technically distinguishable, controllably writable and readable resistance or conductance values. It is noted that resistance and conductance are mutually reciprocal, so one can be determined from the other. For simplicity and without limitation, the present description only refers to the resistance. In a memristor cell, the achievable bit resolution depends on the number of distinguishable resistance values. The number of distinguishable resistance values is also referred to as the number of states of the memristor.

For commercial applications, a high resolution, i.e. a high number of states of a memristor-based matrix element is desirable to improve the performance of artificial neural networks. In particular, the test accuracy of an artificial neural network application increases with a higher number of states. Individual memristors currently under development in research laboratories have a resolution that is smaller than 7 bits. Current commercially used technologies achieve a lower resolution, for instance of 5 distinguishable states, which corresponds to a 3 bit resolution.

E.R. Hsieh et al., in IEEE ELECTRON DEVICE LETTERS, VOL. 42, NO. 3, MARCH 2021, pages 335 to 338, describe a 1MBit array of 1-Transistor-8-Resistive RAM (1T8R) memory to be fabricated monolithically using a foundry logic technology. In this technology, eight parallel memristors with their bottom electrodes electrically connected to the drain of a control transistor to form a subcell (unit cell) of a 1T8R RRAM array. Separate bit lines connect the top electrodes of the eight memristors. Word lines run through the gates of the control transistors. Two control transistors share a source contact and a source line, which runs in parallel with the bit lines. There are separate decoders for the word, bit, and source lines. When a 1T8R cell is selected to be read, the bit lines of all eight memristors are biased by the same read voltage. The word line voltage turns on the selected control transistor and the source line is grounded. The currents of the eight memristors are detected by separate sense amplifiers connected to the bit lines. Using a gradual SET/RESET programming scheme, sixteen resistance levels are stored in each RRAM cell, achieving an 1T8R array with 4 bits per RRAM cell.

SUMMARY OF THE INVENTION

According to the present invention, a resistive memory subcell, herein RRAM subcell, is provided for use in a resistive random access memory. The RRAM subcell comprises

- a subcell circuit arrangement comprising an electrical series connection of interconnected or interconnectable memristors; wherein

- each of the memristors is electrically programmable to assume a selected one of a plurality of memristor states, each memristor state being associated with a respective memristor resistance value or memristor resistance-value range of the given memristor.

The subcell circuit arrangement of the RRAM subcell of the present invention is electrically drivable to assume a selected one of a set of memory subcell states for storing information, the set of memory subcell states comprising those combinations of memristor states in the subcell circuit arrangement, which result from the electrical series connection of the memristors and have mutually distinguishable subcell resistance values or subcell resistance-value ranges.

The RRAM subcell of the invention achieves an improvement in the resolution of resistive memory cells by a circuit-arrangement approach. In particular it allows providing a high number of memory subcell states by an electrical series connection of a suitable number of memristors in a memory subcell. The present invention, instead of aiming at a technological improvement of a memristor in the known conventional 1T1R cell for improving the resolution, i.e., number of memory subcell states for storing information, proposes a subcell or basic building block for a RRAM memory matrix in the form a circuit arrangement comprising an electrical series connection of interconnected or interconnectable memristors. Selecting a number of memristors interconnected or interconnectable in series allows determining the number of states of this RRAM subcell. This way, an increase of the resolution of a weight value stored in one or more RRAM subcells can be achieved.

The distinguishable subcell resistance values may represent a subset of all possible combinations of memristors states. It is noted that some combinations, in particular permutations of a given set of resistance values, may be non-distinguishable in their resulting sum resistance value, as can be determined by application of Kirchhoff's and Ohm's laws for the given subcell circuit arrangement of memristors in their respective memristor states. In comparison with the 1T8R subcell known from the publication of E.R. Hsieh et al., the RRAM subcell of the present invention allows achieving a larger number of distinguishable subcell resistance values using a simpler decoding and readout circuitry, in particular as only a single bit line is required to address the RRAM subcell in a RRAM matrix and the information stored in the RRAM subcell can be determined using a single electrical current signal. In a neural network making use of the RRAM subcell design of the present invention, this allows improving the performance, because the resolution of the synaptic weights is increased.

Furthermore, another advantage of the use of a series connection of memristors in the RRAM cell of the present invention is that it reduces its power requirements and improves dielectric strength. A particularly low current is required in operation.

In addition, the voltage applied for reading can be increased without risking an undesired re-programming of the memristors, which is advantageous in particular in an inference mode of operation.

In embodiments where the circuit arrangement additionally provides an interconnectability of the memristors according to different possible circuit arrangements, the number of states that the RRAM cell can assume may even be pre-set according to the requirements of a given application case. The interconnectability of the memristors can be used to set the number of active resistors contributing to the series connection in the circuit arrangement in a configuration phase. Thus, the number of states of the subcell and hence can be configured to a value between 1 and N, N being the number of memristors present in the RRAM subcell. A suitable configuration control will be explained further below.

The RRAM subcell of the present invention suitably has the subcell circuit arrangement in the form of a matrix-type electrical circuit arrangement of J x K interconnected or interconnectable memristors. Herein, J and K are integers greater than 1. In a given matrix column of this circuit arrangement, at least two of the memristors are mutually interconnectable in a series connection. In a given matrix row, at least two of the memristors are mutually connectable in a parallel connection. This matrix arrangement provides the possibility to select a circuit arrangement by using a desired combination of series connections and parallel connections, which allows achieving a particularly large number of states of the RRAM subcell. Any desired number of states of the RRAM subcell can be achieved by providing memristors in suitable numbers of J matrix rows and K matrix columns,

It is noted that the terms matrix column and matrix row in the description of the last paragraph are interchangeable. Thus, in the matrix-type circuit arrangement of J x K interconnectable memristors, in a given matrix row at least two of the memristors may be series-connectable with each other, and in a given matrix column at least two of the memristors may be parallel-connectable with each other.

For setting a desired configuration, preferably, the subcell circuit arrangement comprises, arranged between one or more pairs of adjacent memristors in at least one matrix column or in at least one matrix row of the subcell circuit, respective subcell configuration switches that are controllable to assume either a closed state to interconnect the given pair of adjacent memristors before operation of the memory subcell or to assume an open state to mutually disconnect the given pair of adjacent memristors before operation of the memory subcell.

The number of configuration switches can be determined with a view to a foreseen application of the RRAM subcells in a RRAM. In one particular embodiment that provides particularly high flexibility in selecting a configuration, the respective subcell configuration switches are arranged between each pair of adjacent memristors in the at least one matrix column or in the at least matrix row of the cell circuit.

In such RRAM subcells, preferably, a subcell configuration interface is provided for receiving and distributing subcell configuration control signals, for opening or closing the respective subcell configuration switches before operation of the memory cell, so as to interconnect at least a subset of the memristors and form a desired electrical subcell circuit arrangement.

Furthermore, including one control transistor with a gate electrode connected to a wordline and a source electrode connected to the circuit arrangement of memristors is advantageous, for switching the subcell between a selected state and a deselected state for read or write operations. It is noted that the terms selected and deselected are used herein with the same meaning as activated and deactivated, respectively.

The circuit arrangement of memristors is preferably connected to only one bitline.

For programming the resistive state of the RRAM subcell, opposite ends of each memristor in a direction of current flow are preferably connected to respective first and second programming electrodes for putting the memristor into a desired memristor state, with the exception of a first memristor that has one of its ends connected to the control transistor.

The RRAM subcell forms a particularly advantageous building block of a RRAM memory, Thus, preferred embodiments of the present invention take the form of a RRAM memory that comprises a matrix arrangement of RRAM subcells according to any of the embodiments described herein.

The RRAM memory preferably comprises a control circuit, which is configured to receive storage data indicative of information to be stored in a given RRAM subcell. The control circuit is configured to determine the desired memristor states of the one or more of the memristors of the given RRAM subcell to be assumed for representing the information to be stored, and to determine write control information indicative of a set of electrical write current amounts suitable for putting the one or more memristors of the given RRAM subcell into the respective desired memristor state.

The control circuit suitably comprises a write driver, which receives the write control information and is connectable to each of the memristors of the given RRAM subcell via their first and second programming electrodes and configured to sequentially provide the determined set of write current amounts for putting the one or more memristors of the given RRAM subcell into the respective desired memristor state.

In these embodiments, the RRAM memory preferably further comprises a write switching circuit, which comprises a plurality of switch pairs for individually connecting respective associated memristors with the write driver via their first and second programming electrodes. Here, the write control information is preferably additionally indicative of those switch pairs associated with respective write current amounts and those selected memristors, which are required for writing the information to be stored to the respective RRAM subcell.

In embodiment having configurable subcells, the RRAM memory preferably further comprises a configuration controller connected to the RRAM subcells, which receives configuration data indicative of a desired subcell circuit configuration, and which is configured to determine and selectively close those configuration switches which are required for the RRAM subcell to form the desired subcell configuration.

Further aspects of the present invention relate to an in-memory processor comprising a plurality of resistive memory subcells according to one of the embodiments of the present invention described herein. In particular, the in-memory processor may comprise the RRAM subcells in a matrix arrangement. The in-memory processor is preferably arranged and configured to perform a vector matrix multiplication of input vector components with weight factors stored in the RRAM subcells. Embodiments of the in-memory processor of the present invention shares the additional features and advantages of the corresponding embodiments of the RRAM subcell and the RRAM memory described herein.

In the following, further embodiments will be described with reference to the drawings.

BRIEF DESCRIPTION OF THE DRAWINGS

Fig. 1 illustrates a known structure of an NxN RRAM matrix that may be used as a memory or for in-memory computing.

Fig. 2 illustrates a known resistive memory subcell that forms an elementary building block of the known RRAM matrix of Fig. 1.'

Fig. 3 illustrates an exemplary embodiment of a resistive memory subcell according to the present invention that may be used as an elementary building block of an RRAM matrix.

Fig. 4 is an illustration of a RRAM subcell connected to a programming unit.

Fig. 5 is an illustration of a configurable RRAM subcell 500.

Fig. 6 is an illustration of a 1TNR memristor matrix with peripherals for programming and inference.

Figs. 7 illustrates an implementation of a 1T2R RRAM subcell.

DETAILED DESCRIPTION OF EMBODIMENTS

Figs. 1 and 2 are described in the introductory section of this specification.

Fig. 3 illustrates an exemplary embodiment of a resistive memory subcell according to the present invention. The a resistive memory subcell 300, herein also referred to as RRAM subcell 300, is provided for use in a resistive random access memory and forms an elementary building block, and thus, seen on a high level, has a function corresponding to that of the known RRAM cell of Fig. 2. However, the internal structure of the RRAM subcell 300 of Fig. 3 differs from that of the RRAM cell of Fig. 2, as will be explained in the following.

The RRAM subcell 300 comprises a subcell circuit arrangement with an electrical series connection of 4 interconnectable memristors $R_1$, $R_2$, $R_3$ and $R_4$. Each of the memristors $R_1$, $R_2$, $R_3$ and $R_4$ is electrically programmable to assume a selected one of a plurality of memristor states. As described previously, the memristor states are associated a respective memristor resistance values or memristor resistance-value ranges of the given memristor. In the latter case, each bit value is associated to a respective range of resistance values Gaps between the resistance values or value ranges allow unambiguously determining a bit value in a read operation even in the presence of noise.

At a first node 302, the memristor $R_4$ of the RRAM subcell 300 is to be connected to a bit line. At a second node 304, the memristor $R_1$ of the RRAM subcell 300 is connected with a drain contact of an NMOS field effect transistor M. In a RRAM matrix, the source contact of the NMOS transistor M of the RRAM subcell 300 is to be connected to a source line (not shown) that is commonly associated with all the RRAM subcells of a given matrix row. In such a RRAM matrix, all RRAM subcells suitably have the same internal structure as the RRAM subcell 300. The NMOS transistor M is to be commonly gated together with corresponding NMOS transistors of the other RRAM subcells via the wordline (not shown). The wordline signal received by the NMOS transistor M is thus to be applied to all RRAM subcells of a given matrix row. Similar to the known RRAM cell of Fig. 2, the transistor M thus serves as a switch for activation or deactivation of the RRAM subcell 300 as an element of a matrix row. The transistor M is also used to define a maximum current through the memristor during the setting of a state of the memristor. The subcell 300 thus forms a 1T4R cell. The transistor M is selected in accordance with a desired setting of the maximum current during programming and thus the formation of the filament in the device. For reading, a resistance as low as possible is desired, so as to allow neglecting it in comparison to the resistance values of the memristors.

The subcell circuit arrangement of the RRAM subcell 300 is electrically programmable to assume a selected one of a set of memory subcell states for storing information. The set of memory subcell states comprises those combinations of memristor states in the subcell circuit arrangement, which result from the electrical series connection of the memristors $R_1$ to $R_4$ and have mutually distinguishable total subcell resistance values or subcell resistance-value ranges. Non-distinguishable states result from permutations of a given set of four resistance values (or ranges) assumed. For instance, if the memristors $R_1$ to $R_4$ assume four different distinguishable resistance values $R_1 = r1$, $R_2 = r2$, $R_3 = r3$, and $R_4 = r4$, a corresponding subcell state assumed by the RRAM subcell is determined by the total ohmic resistance of the series connection of memristors, i.e., by the sum $r1+r2+r3+r4$. Any further combination, where the resistance values of the individual memristors are only permutated, for example, $R_1 = r4$, $R_2 = r3$, $R_3 = r2$, and $R_4 = r1$, is not distinguishable from that subcell state. Thus, only those combinations of resistance values, which yield distinguishable total ohmic resistance values of the series connection of memristors, are usable for storing information.

Based on the above description of this exemplary 1T4R configuration with four memristors, the following is a more general explanation of the number of distinguishable states of an 1TNR cell. For explanatory purposes only it is assumed that an individual memristor used in a RRAM subcell can assume the following five resistance values R = {10kOhm, 20kOhm, ..., 50kOhm}. Thus, a 1T1R cell (which is not an embodiment of the present invention) has five states. An embodiment of an RRAM subcell with a 1T2R configuration according to the present invention with memristors of this type can thus assume a minimal resistance value of R_min = 20kOhm, and a maximal resistance value of R_max = 100kOhm. The set of distinguishable resistance values of the 1T2R configuration of the RRAM subcell 700 is {20kOhm, 30kOhm, 50kOhm, 60kOhm, 70kOhm, 80kOhm, 90kOhm, 100kOhm} and thus comprises 9 different resistive states. Generalizing this consideration for an arbitrary number N of memristors in the RRAM subcell, i.e., to an 1TNR configuration, the number of distinguishable resistive states assumed can be determined using the following formula:

$$R\_1TNR = N * (R\_max - R\_min) +1$$

The information stored in the RRAM subcells 300 is read out by applying a suitable read voltage amount $V_{TE} - V_{Source}$ across the RRAM subcell 300 via an associated bitline while the NMOS transistor M receives a suitable wordline voltage at its gate to select or activate the RRAM subcell 300 by opening the NMOS transistor M as a selecting device to allow a read current flow across the memristors $R_1$ to $R_4$. The read current amount is indicative of the total ohmic resistance of the series connection of the memristors $R_1$ to $R_4$ (plus a drain-source resistance of the selecting device M) and thus of the cell state assumed. The read current can be measured by known techniques, for instance by determining a voltage drop across a measurement resistor.

It is noted again that the 1T4R RRAM subcell of Fig. 3 represents an exemplary configuration in that fewer (down to two) or more than four memristors may be provided in the series connection, in accordance with different embodiments. In principle, there is no upper limit of the number of memristors in the series connection. However, technological limitations exist, for instance with regard to the voltage drop $V_{TE} - V_{Source}$ that can be provided in a read operation by subsequent read circuitry (not shown in Fig. 3).

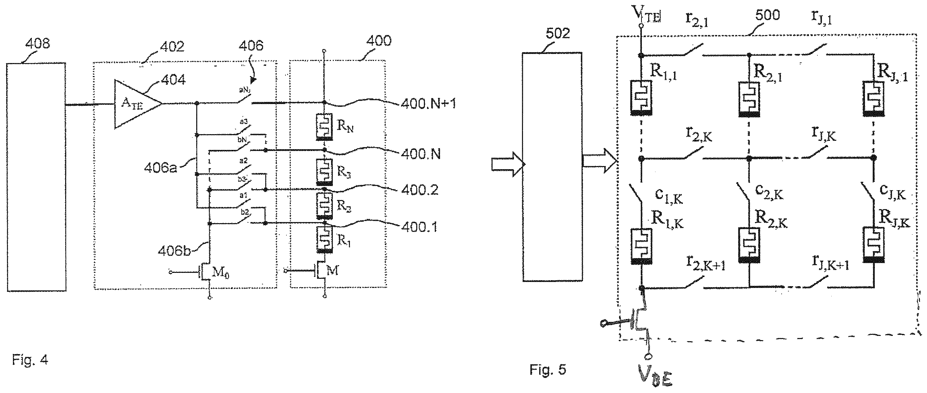

Fig. 4 is an illustration showing a RRAM subcell 400 connected to a programming unit 402 and a control circuit 408. The RRAM subcell 400 resembles the RRAM subcell 300 of Fig. 3. Reference is thus made to the above description of Fig. 3. However, to emphasize the available large range in the number of memristors that may be connected in series, a generic RRAM subcell structure is shown with a number N of memristors $R_1$, $R_2$, $R_3$, ..., Rr, in a series connection. The programming unit 402 has a write amplifier 404 for providing a suitable write voltage. A switch structure 406 comprises two interweaved write switch branches 406a and 406b. Each of the write switch branches 406a and 406b has individually controllable write switches a1, a2, a3...,aN, and b2, b3, ..., bN, respectively. Switch control features are not shown in this illustration for reasons of graphical simplicity. Each of the write switches connects to one respective node 400.1, 400.2, ..., 400.N, or 400.N+1 in the series connection of memristors in the RRAM subcell. The first write switch branch 406a with the write switches a1, a2, a3,...aN, is configured to connect the output of the write amplifier with one or more of the individual nodes 400.1, 400.2, ..., 400.N, 400.N+1, whereas the second write switch branch 406b with the write switches and b2, b3, ..., bN is configured to connect a transistor $M_0$ with one or more of the nodes 400.1, 400.2, ..., 400.N. To program an individual memristor of the RRAM subcell 400, an associated write switch of the write first switch branch 406a is closed to connect the higher-potential node of the memristor (away from the NMOS transistor M) to the write amplifier 404, and an associated write switch of the second write switch branch 406b is closed to connect the lower-potential node of the memristor (i.e., a node oriented towards the drain contact of the NMOS transistor M) to the transistor $M_0$. For instance, the memristor $R_2$ can be programmed by closing the write switches a2 and b2, which will cause a programming current selectively routed through the closed write switch a2, the memristor $R_2$ and its associated nodes 400.2 and 400.1, through the closed write switch b2, and through the transistor $M_0$. For programming the memristor $R_1$ with a desired resistance value, only the write switch a1 connecting the associated higher-potential node 400.1 with the write amplifier 404 needs to be closed. The programming current for memristor R1 is routed through the NMOS transistor M.

For programming the RRAM subcell 400, the control circuit 408 determines the desired memristor states of the one or more of the memristors of the given RRAM subcell to be assumed for representing the information to be stored. The growing of a filament in a memristor typically depends on the amount of energy given to the device and therefore on an applied voltage pulse. Thus, the control circuit 408 determines corresponding write control information indicative of a set of electrical write voltage amounts suitable of applied voltage pulses for putting the memristors of the given RRAM subcell 400 into the respective desired memristor state.

The subcell 400 is thus programmed by programming each memristor one after another, in the described manner to let it assume a respective desired resistance value. To accelerate the programming, two or more programming units may be used in parallel, or an analogue multiplexer can be employed.

The existence of non-distinguishable states of the RRAM subcell 400 may be used by the control circuit 408 for a particularly energy-efficient write operation. In a write operation, the information stored by the RRAM subcell 400 is to be changed by letting the RRAM subcell 400 assume another of its distinguishable subcell states. The control circuit 408 determines, based on its knowledge of the current resistance values assumed by the individual memristors, that particular permutation associated with the desired new RRAM subcell state, i.e., that combination of memristor resistance values, which requires the lowest write energy for changing the total resistance of the RRAM subcell. For instance, assuming N=4, the current state is $R_1 = r1$, $R_2 = r2$, $R_3 = r3$, and $R_4 = r4$, and the desired next subcell state requires the resistance values to be any permutation of r1, r1, r1, r3. For this transition, a particularly low amount of write energy may be achieved by re-programming only two of the memristors, namely, by re-programming the memristor R2 from the value r2 to r1, and the memristor R4 from the value r4 to r1. The resistance values of the memristors R1=r1 and R3=r3 may be left unchanged, which achieves in a particularly low use of energy for the write operation, and also saves time that would be required for reprogramming more memristors. To implement this concept, the control circuit evaluates a predetermined write-energy cost function that assigns a cost amount to any transition between pairs of individual non-distinguishable resistance-set permutations of distinguishable subcell states, and selects that resistance-set permutation of the desired new subcell state, which is associated with the lowest cost for a transition from the currently assumed permutation of the current subcell state to the desired new subcell state. Instead of evaluating a cost function, a prestored look-up table may be used.

Fig. 5 is an illustration of a configurable RRAM subcell 500. The RRAM subcell 500 comprises a matrix-type electrical circuit arrangement of J X K interconnectable memristors arranged in rows such as a first row $R_{1,1}$, $R_{2,1}$..., $R_{J,1}$ and columns such as a last column $R_{J,1}$, $R_{J,2}$... $R_{J,K}$. J and K are integers greater than one.

In a given matrix column at least two of the memristors are mutually interconnectable in a series connection by a respective column configuration switch $c_{l,m}$ where I = 1,2, ...J, and m=1 ,2,..., K. In a given matrix row at least two of the memristors are mutually connectable in a parallel connection by a respective row configuration switch $r_{l,m}$ where I = 1,2, ...J, and m=1,2,..., K+1. The individual row configuration switches and column configuration switches form respective subcell configuration switches that are controllable to assume either a closed state to interconnect a respective pair of associated adjacent memristors. In their open state, the subcell configuration switches disconnect a given associated pair of adjacent memristors. The configuration of the subcell is to be performed before operation of the memory subcell by setting all switches according to the desired circuit arrangement of memristors of the subcell 500. In a RRAM memory formed of a matrix arrangement of RRAM subcells of the type of the RRAM subcell 500, each RRAM subcell is thus configured before operation of the RRAM memory, in particular before an inference operation of the RRAM matrix in a crossbar configuration. In preferred embodiments, all RRAM subcells of a RRAM memory are configured to assume the same subcell circuit arrangement of memristors.

As for the RRAM subcell 400, only a single bitline and one source line contact is required and used to write to the RRAM subcell 500 and read from the RRAM subcell 500. For programming the RRAM subcell 500, a similar arrangement as that shown for the embodiment of Fig. 4 can be used. A suitable programming unit comprises an arrangement of write switches that allows individual addressing the memristors of the subcell 500 in a write operation.

The RRAM subcell 500 provides a large number of configuration options. Each individual configuration option corresponds to a particular electrical circuit arrangement of the memristors of the RRAM subcell 500 and has a respective set of resistive subcell states that can be assumed by programming the individual memristors of the RRAM subcell 500.

The RRAM subcell 500 has a subcell configuration interface 502 for receiving and distributing subcell configuration control signals for opening or closing the respective subcell configuration switches, so as to interconnect at least a subset of the memristors and form a desired electrical subcell circuit arrangement.

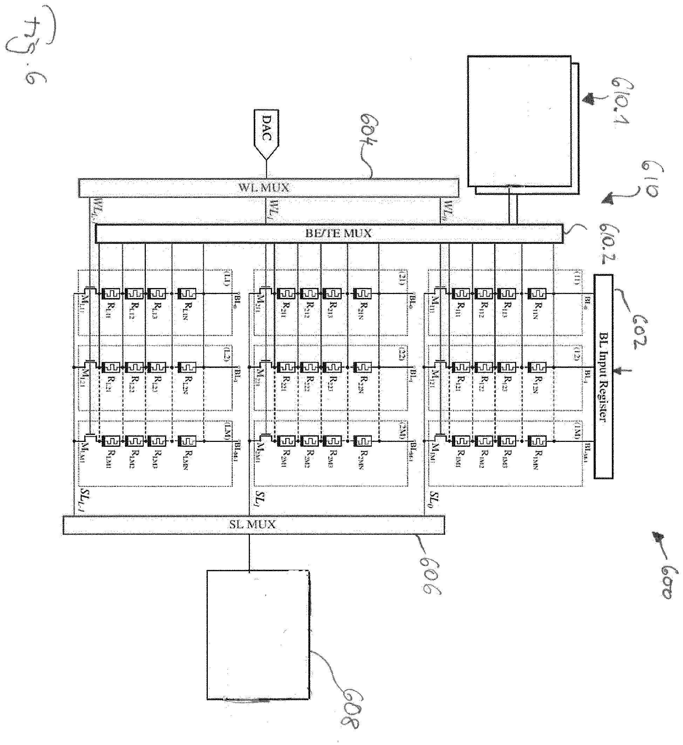

Fig. 6 is a 1TNR memristor matrix 600 comprising a matrix arrangement of RRAM subcells and peripherals for programming and inference. 600. The RRAM subcells are generally of the type of the RRAM subcell 300 described above with reference to Fig. 3. However, a number N of memristors per RRAM subcell is not specified. It may take any value larger or equal than 2, for instance 2, 3, 4, 5 or 6 memristors. The RRAM subcells form matrix nodes in an array of L rows and M columns. Each RRAM subcell or matrix node can thus be identified by matrix coordinates. This is indicated by respective reference labels of the subcells (11), (12), (1M) in the first matrix row, (21), (22), (23) in the second matrix row, and so forth, up to the last matrix row with subcells (L1), (L2) and (LM).

Each matrix column of RRAM subcells is connected to a bit line (BL) input register 602, which receives and provides input values to the RRAM subcells of the matrix columns. The input values may for instance be vector component values provided by a previous layer of an artificial neural network.

Each matrix row of RRAM subcells is connected to a word line multiplexer (WL MUX) 604, which receives and applies a word line voltage to select transistors of the RRAM subcells via wordlines $WL_0$, $WL_1$, and $WL_{L-1}$. For instance, the select transistors $M_{111}$, M121, $M_{1M1}$ of the RRAM subcells (11), (12), (1M) in the first matrix row are addressed via the wordline $WL_0$. Furthermore, the transistors of the RRAM subcells in each matrix row are connected to a respective source line $SL_0$, $SL_1$, $SL_{L-1}$ which is connected to a source line multiplexer (SL MUX) 604, which connects to a current read out unit 608. The current read out unit 608 is configured to perform a current measurement of the sum current received from a given selected matrix row. It may additionally perform a conversion of the sum current to a corresponding analog voltage for output to a next layer of an artificial neural network, or analog to digital conversion for output.

A programming and reading front end 610 comprises a programming and read driver arrangement 610.1 and a multiplexer arrangement 610.2 (BE/TE MUX) to provide output of respective programming voltages or reading voltages to the individual memristors of selected storage cells. There may be an individual programming and read driver for each matrix row.

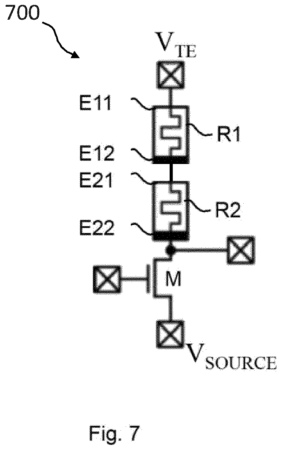

Figs. 7 shows an implementation of a 1T2R RRAM subcell with two memristors R1 and R2. In the RRAM subcell 700 of Fig. 7, the first programming electrode E11 of the first memristor R1 is connected facing a bit line contact, and the second programming electrode E22 of the second memristor R2 is connected with a drain of the NMOS transistor M.

In summary, a RRAM subcell suited for use in a matrix with a crossbar configuration comprises a subcell circuit arrangement having an electrical series connection of interconnected or interconnectable memristors. Each of the memristors is electrically programmable to assume a selected one of a plurality of memristor states, each memristor state being associated with a respective memristor resistance value or memristor resistance-value range of the given memristor. The subcell circuit arrangement is electrically drivable to assume a selected one of a set of memory subcell states for storing information, the set of memory subcell states comprising those combinations of memristor states in the subcell circuit arrangement, which result from the electrical series connection of the memristors and have mutually distinguishable subcell resistance values or subcell resistance-value ranges. The electrical circuit arrangement of the RRAM subcell can be operated using a single bitline. The matrix may be used to store weights which represent synaptic connections of an artificial neural network model.

**Claims**

1. A resistive memory subcell (300), herein RRAM subcell, for use in a resistive random access memory (600), the RRAM subcell (300) comprising:

   - a subcell circuit arrangement comprising an electrical series connection of interconnected or interconnectable memristors (R1, R2, R3, R4); wherein
   - each of the memristors (R1, R2, R3, R4) is electrically programmable to assume a selected one of a plurality of memristor states, each memristor state being associated with a respective memristor resistance value or memristor resistance-value range of the given memristor; and wherein
   - the subcell circuit arrangement is electrically drivable to assume a selected one of a set of memory subcell states for storing information, the set of memory subcell states comprising those combinations of memristor states in the subcell circuit arrangement, which result from the electrical series connection of the memristors (R1, R2, R3, R4) and have mutually distinguishable subcell resistance values or subcell resistance-value ranges.

2. The RRAM subcell (500) of claim 1, wherein

   - the subcell circuit arrangement is a matrix-type electrical circuit arrangement of J x K interconnected or interconnectable memristors, J and K being integers greater than one; and wherein
   - in a given matrix column at least two of the memristors (R1,1; R1K) are mutually interconnectable in a series connection, and in a given matrix row at least two of the memristors (R1,1; R2,1) are mutually connectable in a parallel connection.

3. The RRAM subcell (300, 500) of claim 1 or 2, wherein

   - the subcell circuit arrangement comprises, arranged between one or more pairs of adjacent memristors in at least one matrix column or in at least one matrix row of the subcell circuit, respective subcell configuration switches (r2,1, c1,K) that are controllable to assume either a closed state to interconnect the given pair of adjacent memristors before operation of the memory subcell or to assume an open state to mutually disconnect the given pair of adjacent memristors before operation of the memory subcell.

4. The RRAM subcell (500) of claim 3, wherein

   - the respective subcell configuration switches (r2,1, c1,K) are arranged between each pair of adjacent memristors in the at least one matrix column or in the at least matrix row of the cell circuit.

5. The RRAM subcell (500) of claim 3 or 4, further comprising

   - a subcell configuration interface (502) for receiving and distributing subcell configuration control signals for opening or closing the respective subcell configuration switches (r2,1, c1,K) before operation of the RRAM subcell, so as to interconnect at least a subset of the memristors and form a desired electrical subcell circuit arrangement.

6. The RRAM subcell (300, 500) of any of the preceding claims, wherein

   - the electrical subcell circuit arrangement further comprises one control transistor (M) with a gate electrode connected to a wordline and a source electrode connected to the circuit arrangement of memristors, for switching the subcell between a selected state and a deselected state for read or write operations.

**7.** The RRAM subcell (300, 500) of any of the claims 2 to 6, wherein the circuit arrangement of memristors is configured to connect to only one bitline.

**8.** The RRAM subcell (400, 700) of any of the previous claims, wherein

- opposite ends of each memristor in a direction of current flow are connected to respective first and second programming electrodes for putting the memristor into a desired memristor state, with the exception of a first memristor that has one of its ends connected to the control transistor.

**9.** A RRAM memory (600), comprising

- a matrix arrangement of RRAM subcells (300, S11, S12, ...,S1M; S21, ..., SN1) wherein the RRAM subcells are according to any of the preceding claims.

**10.** The RRAM memory of claim 9, further comprising a control circuit (408), which is configured to receive storage data indicative of information to be stored in a given RRAM subcell, wherein the control circuit (408) is configured to determine the desired memristor states of the one or more of the memristors of the given RRAM subcell to be assumed for representing the information to be stored, and to determine write control information indicative of a set of electrical write current amounts suitable for putting the one or more memristors of the given RRAM subcell into the respective desired memristor state.

**11.** The RRAM memory of claim 10, wherein the control circuit comprises a write driver (402), which receives the write control information and is connectable to each of the memristors of the given RRAM subcell (400) via their first and second programming electrodes and configured to sequentially provide the determined set of write current amounts for putting the one or more memristors of the given RRAM subcell into the respective desired memristor state.

**12.** The RRAM memory of claim 11, further comprising a write switching circuit, wherein the write driver (402) comprises a plurality of switch pairs (a2, b2) for individually connecting respective associated memristors (R2) with the write driver (402) via their first and second programming electrodes, wherein the write control information is additionally indicative of those switch pairs associated with respective write current amounts and those selected memristors, which are required for writing the information to be stored to the respective RRAM subcell.

**13.** The RRAM memory of any of the claims 9 to 12, comprising

- RRAM subcells (500) according to any of the claims 3 to 5, and
- a configuration controller (502) connected to the RRAM subcells (500), which receives configuration data indicative of a desired subcell circuit configuration, and which is configured to determine and selectively close those configuration switches which are required for the RRAM subcell (500) to form the desired subcell configuration.

**14.** An in-memory processor comprising a plurality of resistive memory subcells (300) according to claim 1.

**15.** The in-memory processor of claim 14, comprising the RRAM subcells in a matrix arrangement.

Fig. 1

- Prior Art -

Fig. 2

- Prior Art -

Fig. 3

Fig. 4

Fig. 5

Fig. 6

DAC

WL MUX — 604

BE/TE MUX — 610.2

BL Input Register — 602

SL MUX — 606

610.1
610
600
608

Fig. 7

700

V_SOURCE

M

E11 E12 E21 E22

R1 R2

V_TE

EP 4 345 823 A1

Europäisches Patentamt
European Patent Office
Office européen des brevets

# EUROPEAN SEARCH REPORT

Application Number

EP 22 21 4910

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GB 2 552 014 A (ADVANCED RISC MACH LTD [GB]) 10 January 2018 (2018-01-10) * page 19, paragraph 2 – page 26, paragraph 2; figures 1-7 * ----- | 1-15 | INV. G11C13/00 G11C11/56 G11C11/54 G06N3/063 |
| X | WO 2021/120136 A1 (UNIV ZHEJIANG [CN]) 24 June 2021 (2021-06-24) * figures 1-7 * -& US 2022/319596 A1 (ZHAO YI [CN] ET AL) 6 October 2022 (2022-10-06) * paragraph [0042] – paragraph [0076]; figures 1-7 * ----- | 1,3-7, 9-15 | |
| X | US 2017/178724 A1 (BHAVNAGARWALA AZEEZ JENNUDIN [US] ET AL) 22 June 2017 (2017-06-22) * paragraphs [0049] – [0053]; figures 3,4; table 3 * * paragraphs [0077] – [0081]; figures 9-10 * ----- | 1,9-12, 14,15 | |
| A | WO 2022/135009 A1 (ZHEJIANG HIKSTOR TECH CO LTD [CN]) 30 June 2022 (2022-06-30) * the whole document * ----- | 1-15 | TECHNICAL FIELDS SEARCHED (IPC) G11C G06N |
| A | US 2021/064979 A1 (IDO TORU [GB] ET AL) 4 March 2021 (2021-03-04) * paragraphs [0055] – [0058]; figure 4 * ----- | 1-15 | |

The present search report has been drawn up for all claims

| Place of search | Date of completion of the search | Examiner |
|---|---|---|
| The Hague | 8 August 2023 | Colling, Pierre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

14

## ANNEX TO THE EUROPEAN SEARCH REPORT
## ON EUROPEAN PATENT APPLICATION NO.

EP 22 21 4910

This annex lists the patent family members relating to the patent documents cited in the above-mentioned European search report.
The members are as contained in the European Patent Office EDP file on
The European Patent Office is in no way liable for these particulars which are merely given for the purpose of information.

08-08-2023

| Patent document cited in search report | | Publication date | Patent family member(s) | | Publication date |
|---|---|---|---|---|---|
| GB 2552014 | A | 10-01-2018 | CN | 109416760 A | 01-03-2019 |
| | | | GB | 2552014 A | 10-01-2018 |
| | | | KR | 20190022622 A | 06-03-2019 |
| | | | US | 2019236445 A1 | 01-08-2019 |
| | | | WO | 2018007783 A1 | 11-01-2018 |
| WO 2021120136 | A1 | 24-06-2021 | US | 2022319596 A1 | 06-10-2022 |
| | | | WO | 2021120136 A1 | 24-06-2021 |
| US 2022319596 | A1 | 06-10-2022 | US | 2022319596 A1 | 06-10-2022 |
| | | | WO | 2021120136 A1 | 24-06-2021 |
| US 2017178724 | A1 | 22-06-2017 | CN | 108604459 A | 28-09-2018 |
| | | | KR | 20180098309 A | 03-09-2018 |
| | | | TW | 201801082 A | 01-01-2018 |
| | | | US | 2017178724 A1 | 22-06-2017 |
| | | | US | 2017206963 A1 | 20-07-2017 |
| | | | US | 2018218772 A1 | 02-08-2018 |
| | | | WO | 2017109460 A1 | 29-06-2017 |
| WO 2022135009 | A1 | 30-06-2022 | CN | 114678047 A | 28-06-2022 |
| | | | WO | 2022135009 A1 | 30-06-2022 |
| US 2021064979 | A1 | 04-03-2021 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

• **E.R. HSIEH et al.** *IEEE ELECTRON DEVICE LET-TERS,* March 2021, vol. 42 (3), 335-338